# EUROPÄISCHE PATENTSCHRIFT

(11) **EP 0 968 527 B1**
(45) Veröffentlichungstag und Bekanntmachung des Hinweises auf die Patenterteilung: **17.07.2002**
(21) Anmeldenummer: 98913703.9
(22) Anmeldetag: 11.03.1998
(51) Int. Cl.: H01L 21/336, H01L 29/78

(54) **VERFAHREN ZUR HERSTELLUNG EINES VERTIKALEN MOS-TRANSISTORS**
METHOD FOR PRODUCING A VERTICAL MOS-TRANSISTOR
PROCEDE DE PRODUCTION D'UN TRANSISTOR MOS VERTICAL

(30) Priorität: 19.03.1997 DE 19711482
(43) Veröffentlichungstag der Anmeldung: 05.01.2000
(73) Patentinhaber: Infineon Technologies AG, 81669 München (DE); Ruhr-Universität Bochum, 44801 Bochum (DE)
(72) Erfinder: AEUGLE, Thomas, D-81735 München (DE); RÖSNER, Wolfgang, D-81739 München (DE); BEHAMMER, Dag, D-89079 Ulm (DE)
(74) Vertreter: Kindermann, Peter, Dipl.-Ing.
(86) Internationale Anmeldenummer: EP9801407
(87) Internationale Veröffentlichungsnummer: WO9842016

(56) Entgegenhaltungen:
- DE-A- 19 621 244
- GB-A- 2 103 879
- US-A- 4 740 826

## Beschreibung

Im Hinblick auf immer schnellere Bauelemente bei höherer Integrationsdichte nehmen die Strukturgrößen integrierter Schaltungen von Generation zu Generation ab. Dieses gilt auch für die CMOS-Technologie. Es wird allgemein erwartet (siehe zum Beispiel Roadmap of Semiconductor Technology, Solid State Technology 3, 1995), daß um das Jahr 2010 MOS-Transistoren mit einer Gatelänge von weniger als 100 nm eingesetzt werden.

Einerseits wird versucht, durch Skalierung der heute üblichen CMOS-Technologie planare MOS-Transistoren mit derartigen Gatelängen zu entwickeln (siehe zum Beispiel A. Hori, H. Nakaoka, H. Umimoto, K. Yamashita, M. Takase, N. Shimizu, B. Mizuno, S. Odanaka, A 0.05 µm-CMOS with Ultra Shallow Source/Drain Junctions Fabricated by 5 keV Ion Implantation and Rapid Thermal Annealing, IEDM 1994, 485 und H. Hu, L. T. Su, Y. Yang, D. A. Antoniadis, H. I. Smith, Channel and Source/Drain Engineering in High-Performance sub-0,1 µm NMOSFETs using X-Ray lithography, Symp. VLSI Technology, 17, 1994). Derartige planare MOS-Transistoren mit Kanallänge unter 100 nm herzustellen, erfordert den Einsatz von Elektronenstrahllithographie und ist bisher nur im Labormaßstab möglich. Der Einsatz der Elektronenstrahllithographie führt zu einer überproportionalen Steigerung der Entwicklungskosten.

Parallel dazu werden zur Realisierung kurzer Kanallängen vertikale Transistoren untersucht (siehe L. Risch, W. H. Krautschneider, F. Hofmann, H. Schäfer, Vertical MOS Transistor with 70 nm channel length, ESSDERC 1995, Seiten 101 bis 104). Dabei werden Schichtenfolgen entsprechend Source, Kanal und Drain gebildet, die ringförmig von Gatedielektrikum und Gateelektrode umgeben sind. Diese vertikalen MOS-Transistoren sind im Vergleich zu planaren MOS-Transistoren bezüglich ihrer Hochfrequenz- und Logikeigenschaften bisher unbefriedigend.

In der den Oberbegriff des Patentanspruchs 1 bildenden DE-OS 196 21 244 ist ein MOS-Transistor mit reduzierten parasitären Kapazitäten des Gates vorgeschlagen worden, der für Hochfrequenzanwendungen geeignet ist. Zur Herstellung dieses vertikalen Transistors wird auf einem Halbleitersubstrat eine Mesastruktur gebildet, die in vertikaler Aufeinanderfolge Sourcegebiet, Kanalgebiet und Draingebiet umfaßt. Die Gateelektrode wird so gebildet, daß sie nur im Bereich des Kanalgebiets an die Mesastruktur angrenzt. Unterhalb und oberhalb der Gateelektrode im Bereich des Sourceund Draingebietes werden Oxidstrukturen gebildet, die die Gateelektrode einbetten. Auf diese Weise werden die Gatekapazitäten minimiert. Zur Herstellung der Oxidstrukturen und der Gateelektrode werden jeweils entsprechende Schichten abgeschieden, die den Mesa bedecken. Darauf wird Photolack aufgebracht und planarisiert. Anschließend wird der Photolack soweit rückgeätzt, daß die Mesaoberseiten frei stehenbleiben. Dieser strukturierte Photolack wird anschließend als Maske verwendet, um die darunter befindliche Schicht im Bereich des Mesas zu strukturieren. Die Dicke der Schicht ist jeweils geringer als die Höhe des Mesa. Da die Planarität von durch Verfließen von planarisiertem Photolack begrenzt ist, ist die Höhe des Ätzabtrags der weiteren Strukturierung der Photolackschicht durch Ätzen schwer kontrollierbar.

Der Erfindung liegt daher das Problem zugrunde, ein Verfahren zur Herstellung eines vertikalen MOS-Transistors mit reduzierten Gateüberlappkapazitäten anzugeben, das bezüglich der Prozeßsicherheit wesentlich verbessert ist.

Dieses Problem wird erfindungsgemäß gelöst durch ein Verfahren nach Anspruch 1. Weitere Ausgestaltungen der Erfindung gehen aus den Unteransprüchen hervor.

Es wird aus einer Halbleiterschichtenfolge eine Mesastruktur gebildet, die ein unteres Source-/Draingebiet, ein Kanalgebiet und ein oberes Source-/Draingebiet aufweist. Die Halbleiterschichtenfolge wird durch Epitaxie oder durch Implantation und Ausheilen gebildet. Auf die Halbleiterschichtenfolge wird eine erste Hilfsschicht aufgebracht, die gemeinsam mit der Halbleiterschichtenfolge strukturiert wird. Seitlich der Mesastruktur wird im Halbleitersubstrat ein Anschlußgebiet für das untere Source-/Draingebiet gebildet. Es wird eine Isolationsstruktur gebildet, die mindestens die Seitenwand des unteren Source-/Draingebietes im wesentlichen bedeckt. An der Seite des Kanalgebiets wird ein Gatedielektrikum und eine Gateelektrode gebildet. Die Höhe der Gateelektrode ist im wesentlichen gleich der Höhe des Kanalgebiets. Zur Bildung der Isolationsstruktur wird eine isolierende Schicht aufgebracht, deren Dicke größer oder gleich der Dicke der Halbleiterschichtenfolge ist. Die isolierende Schicht wird durch chemisch-mechanisches Polieren planarisiert. Dabei wird die erste Hilfsschicht, die sich als oberste Schicht auf der Mesastruktur befindet, als Ätzstop verwendet.

Durch das chemisch-mechanische Polieren wird eine ebene Fläche gebildet, in der die Oberfläche der ersten Hilfsschicht freiliegt. Damit ist eine Referenzebene für nachfolgende Rückätzschritte gegeben. Die Tiefe des Ätzabtrags bei nachfolgenden Rückätzschritten ist dadurch gegenüber dem Stand der Technik besser kontrollierbar.

Gemäß einer Ausführungsform der Erfindung wird die isolierende Schicht mit im wesentlichen konformer Kantenbedeckung aufgebracht. Ihre Dicke ist dabei im wesentlichen gleich der Dicke der Halbleiterschichtenfolge. Das heißt seitlich der Mesastruktur befindet sich die Oberfläche der isolierenden Schicht auf einer Höhe mit der Oberfläche des oberen Source/Draingebietes der Mesastruktur.

Es wird eine zweite Hilfsschicht aufgebracht, die dieselben Ätzeigenschaften und im wesentlichen die gleiche Dicke wie die erste Hilfsschicht aufweist. Seitlich der Mesastruktur ist daher die Oberfläche der zweiten Hilfsschicht auf einer Höhe mit der Oberfläche der ersten Hilfsschicht angeordnet. Die zweite Hilfsschicht wird anschließend so strukturiert, daß die Oberfläche der isolierenden Schicht mindestens in einem ersten Bereich freigelegt wird. Der erste Bereich überlappt die Mesastruktur seitlich. Die lateralen Abmessungen des ersten Bereichs sind jeweils mindestens um das Doppelte der Schichtdicke der isolierenden Schicht größer, als es der entsprechenden lateralen Abmessung der Mesastruktur entspricht. Damit bedeckt die zweite Hilfsschicht die isolierende Schicht in dem Teil, der außerhalb der Mesastruktur angeordnet ist und in dem sich die Erhebung der Mesastruktur nicht auf die Topologie der isolierenden Schicht auswirkt. Mit anderen Worten: bei der Strukturierung der zweiten Hilfsschicht wird der Teil der zweiten Hilfsschicht entfernt, in dem die Oberfläche der zweiten Hilfsschicht oberhalb der Oberfläche der ersten Hilfsschicht angeordnet ist. Nach der Strukturierung der zweiten Hilfsschicht sind die Oberfläche der ersten Hilfsschicht und die Oberfläche der zweiten Hilfsschicht überall auf einer Höhe angeordnet.

Durch chemisch-mechanisches Polieren der isolierenden Schicht wird anschließend die Oberfläche der ersten Hilfsschicht freigelegt. Die erste Hilfsschicht und die zweite Hilfsschicht wirken dabei als Ätzstop.

Anschließend wird unter Verwendung der ersten Hilfsschicht und der zweiten Hilfsschicht als Maske die isolierende Schicht soweit geätzt, daß die Seitenwand des Kanalgebietes im wesentlichen freigelegt wird. Unterhalb des Kanalgebietes wird die isolierende Schicht nicht geätzt, so daß an der Seitenwand zur Mesastruktur die isolierende Schicht bis an die Grenzfläche zwischen dem unteren Source-/Draingebiet und dem Kanalgebiet reicht.

An der freigelegten Seitenwand des Kanalgebietes wird ein Gatedielektrikum gebildet.

Es wird eine leitfähige Schicht erzeugt, die den Zwischenraum zwischen der isolierenden Schicht und der Mesastruktur im wesentlichen auffüllt. Der Zwischenraum zwischen der isolierenden Schicht und der Mesastruktur entsteht durch das Ätzen der isolierenden Schicht bis auf die obere Grenzfläche des unteren Source-/Draingebietes. Durch Rückätzen der leitfähigen Schicht wird anschließend die Gateelektrode gebildet.

Vorzugsweise wird die zweite Hilfsschicht so strukturiert, daß die Oberfläche der isolierenden Schicht zusätzlich in einem zweiten Bereich freigelegt wird. Beim Ätzen der isolierenden Schicht zum Freilegen der Seitenwand des Kanalgebietes wird die isolierende Schicht auch im zweiten Bereich geätzt, so daß im zweiten Bereich und im ersten Bereich eine zusammenhängende Öffnung entsteht. Beim Bilden der leitfähigen Schicht wird diese Öffnung im wesentlichen aufgefüllt. Die durch Rückätzen der leitfähigen Schicht gebildete Gateelektrode weist somit den Querschnitt der Öffnung auf. Im späteren Prozeßverlauf wird ein Kontaktloch für die Gateelektrode in dem zweiten Bereich geöffnet.

Es ist besonders vorteilhaft, bei der Strukturierung der zweiten Hilfsschicht im zweiten Bereich Hilfsstrukturen vorzusehen, die bei der Strukturierung der isolierenden Schicht Inseln aus dem Material der isolierenden Schicht in der Öffnung bewirken. Im zweiten Bereich weist die Öffnung und damit die Gateelektrode einen gitterförmigen Querschnitt auf. Dann ist zum Auffüllen der Öffnung mit der leitfähigen Schicht eine Dicke der leitfähigen Schicht entsprechend den Abmessungen der Öffnung ausreichend. Darüber hinaus hat der gitterförmige Querschnitt der Gateelektrode im zweiten Bereich den Vorteil, daß beim Öffnen des Kontaktloches zu der Gateelektrode die Justierung unkritisch ist. Vorzugsweise werden die Inseln so angeordnet, daß der Abstand zwischen gegenüberliegenden Inseln im zweiten Bereich nicht größer ist als der Abstand zwischen der Seitenwand der Mesastruktur und der gegenüberliegenden Seitenwand der isolierenden Schicht im ersten Bereich. Dadurch wird die erforderliche Dicke der leitfähigen Schicht reduziert.

Es liegt im Rahmen der Erfindung, vor dem Entfernen der ersten Hilfsschicht und der zweiten Hilfsschicht eine dritte Hilfsschicht aufzubringen. Zu der dritten Hilfsschicht sind die erste Hilfsschicht und die zweite Hilfsschicht selektiv ätzbar. Die dritten Hilfsschicht wird so strukturiert, daß die erste Hilfsschicht freigelegt wird und daß der zweite Bereich von der dritten Hilfsschicht bedeckt ist. Auf diese Weise wird erreicht, daß die erste Hilfsschicht, die an der Oberfläche der Mesastruktur angeordnet ist, entfernt werden kann, während die zweite Hilfsschicht im zweiten Bereich an der Oberfläche der Siliziuminseln verbleibt. Damit wird erreicht, daß beim Fertigstellen der Struktur Kontaktlöcher zu den Anschlußgebieten des unteren Source-/Draingebietes und Kontaktlöcher zu der Gateelektrode separat geätzt werden können. Damit wird ein Durchätzen der isolierenden Schicht im Bereich der Inseln im zweiten Bereich, das zu Kurzschlüssen zwischen dem Halbleitersubstrat und der Gateelektrode führen kann, vermieden.

Es liegt im Rahmen der Erfindung, daß die erste Hilfsschicht und die zweite Hilfsschicht Si₃N₄ enthalten und die dritte Hilfsschicht, soweit vorhanden, Polysilizium enthält. Die isolierende Schicht und die isolierende Füllung enthalten SiO₂. Die leitfähige Schicht enthält dotiertes Polysilizium, Metallsilizid, Metall und/oder eine Kombination aus diesen Materialien. Für die leitfähige Schicht ist jedoch Material geeignet, das für Gateelektroden tauglich ist.

In einer anderen Ausführungsform der Erfindung wird die isolierende Schicht durch chemisch-mechanisches Polieren bis auf die Höhe der ersten Hilfsschicht abgetragen. Anschließend wird sie durch Rückätzen strukturiert, wobei die Isolationsstruktur, die seitlich der Mesastruktur angeordnet ist und deren Dicke im wesentlichen gleich der Höhe des unteren Source-/Draingebietes ist, gebildet wird. Die Seitenwand des Kanalgebietes wird dabei ebenfalls freigelegt. An der Seitenwand des Kanalgebietes wird ein Gatedielektrikum gebildet. Zur Bildung der Gateelektrode wird eine leitfähige Schicht abgeschieden und strukturiert. Dabei werden Teile der leitfähigen Schicht, die an den Seitenwänden des Mesas oberhalb des Kanalgebietes bzw. an der Oberfläche des Mesas angeordnet sind, entfernt. Eine weitere isolierende Schicht wird aufgebracht, die die Gateelektrode bedeckt.

Es liegt im Rahmen der Erfindung, daß die isolierende Schicht, die weitere isolierende Schicht und/oder die isolierende Füllung SiO₂ enthalten, daß die erste Hilfsschicht Siliziumnitrid enthält. Für die leitfähige Schicht sind alle Materialien geeignet, die als Gateelektrodenmaterial üblich sind, insbesondere dotiertes Polysilizium, Metallsilizid, Metall und/oder eine Kombination aus diesen Materialien.

Im folgenden wird die Erfindung anhand von Ausführungsbeispielen, die in den Figuren dargestellt sind, näher erläutert.
- Figur 1: zeigt ein Halbleitersubstrat mit einer Halbleiterschichtenfolge und einer ersten Hilfsschicht.
- Figur 2: zeigt das Halbleitersubstrat nach Bildung einer Mesastruktur durch Strukturieren der Halbleiterschichtenfolge, nach Bildung von Spacern an den Seitenwänden der Mesastruktur, und nach Bildung eines Anschlußgebietes.
- Figur 3: zeigt das Halbleitersubstrat nach Aufbringen einer isolierenden Schicht und Aufbringen und Strukturieren einer zweiten Hilfsschicht.
- Figur 4: zeigt eine Aufsicht auf Figur 3.
- Figur 5: zeigt einen Schnitt durch das Halbleitersubstrat nach Planarisieren der isolierenden Schicht.
- Figur 6: zeigt einen Schnitt durch das Halbleitersubstrat nach teilweisem Freilegen der Seitenwand der Mesastruktur und Bildung eines Gatedielektrikums an der freigelegten Seitenwand der Mesastruktur.
- Figur 7: zeigt einen Schnitt durch das Halbleitersubstrat nach Bildung einer Gateelektrode.
- Figur 8: zeigt das Halbleitersubstrat nach Bildung einer Metallsilizidschicht an der Oberfläche der Gateelektrode, nach Bildung einer isolierenden Füllung oberhalb der Gateelektrode, die in der Höhe mit der ersten und zweiten Hilfsschicht abschließt und nach Abscheidung und Strukturierung einer dritten Hilfsschicht.
- Figur 9: zeigt einen Schnitt durch das Halbleitersubstrat nach Bildung von Kontakten.
- Figur 10: zeigt einen Schnitt durch ein Halbleitersubstrat mit einer Mesastruktur, die als oberste Schicht eine erste Hilfsschicht aufweist und mit einem Anschlußgebiet im Halbleitersubstrat.
- Figur 11: zeigt einen Schnitt durch das Halbleitersubstrat nach Bildung von Metallsilizidschichten an der Oberfläche des Anschlußgebietes und nach Bildung einer isolierenden Schicht, die in einer größeren Dicke als die Mesastruktur und die erste Hilfsschicht abgeschieden wird und die anschließend planarisiert wird.
- Figur 12: zeigt einen Schnitt durch das Halbleitersubstrat nach Rückätzen der isolierenden Schicht und Bildung eines Gatedielektrikums an den Seitenwänden der Mesastruktur.
- Figur 13: zeigt einen Schnitt durch das Halbleitersubstrat nach Bildung einer weiteren isolierenden Schicht, deren Dicke größer ist, als es der Höhe der freigelegten Mesastruktur entspricht und Planarisierung der weiteren isolierenden Schicht.
- Figur 14: zeigt den Schnitt durch das Halbleitersubstrat nach Rückätzen der isolierenden Schicht.
- Figur 15: zeigt das Halbleitersubstrat nach Entfernen der ersten Hilfsschicht, nach Bildung einer Metallsilizidschicht an der freigelegten Oberfläche der Mesastruktur und nach Bildung von Kontakten.

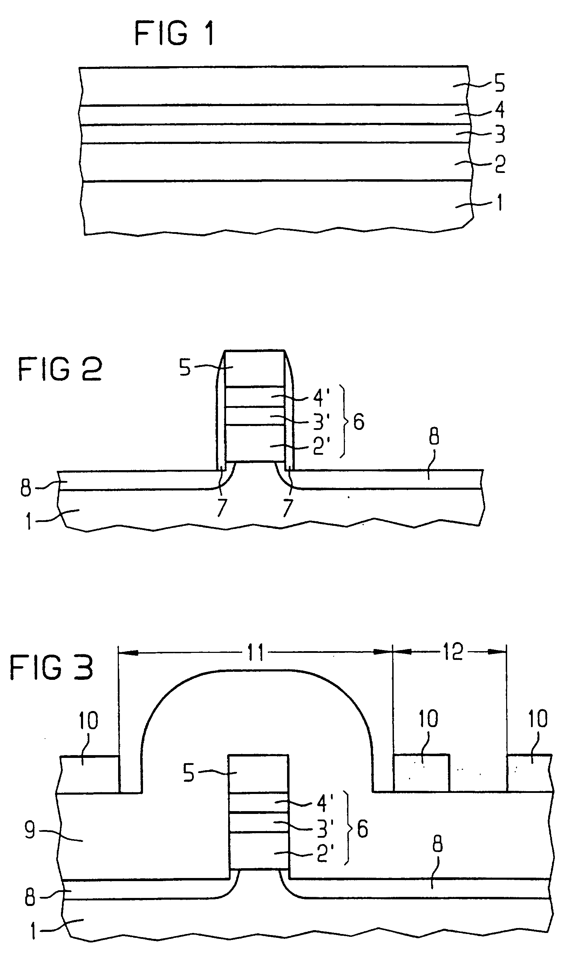

Auf ein Substrat 1, zum Beispiel eine monokristalline Siliziumscheibe oder die monokristalline Siliziumschicht eines SOI-Substrates, wird eine erste Siliziumschicht 2, eine zweite Siliziumschicht 3 und eine dritte Siliziumschicht 4 aufgebracht. Die erste Siliziumschicht 2, die zweite Siliziumschicht 3 und die dritte Siliziumschicht 4 werden dabei jeweils durch in situ dotierte Epitaxie unter Verwendung eines Si₂H₂Cl₂, B₂H₆, AsH₃, PH₃, HCl, H₂ enthaltenden Prozeßgases im Temperaturbereich 700°C bis 950°C und Druckbereich 100 bis 10 000 Pa gebildet. Die erste Siliziumschicht 2 wird in einer Dicke von 200 nm aus n-dotiertem Silizium mit einer Dotierstoffkonzentration von 5 x 10¹⁹ cm⁻³ gebildet. Die zweite Siliziumschicht 3 wird in einer Dicke von 100 nm aus p-dotiertem Silizium mit einer Dotierstoffkonzentration von 10¹⁸ cm⁻³ gebildet. Die dritte Siliziumschicht 4 wird in einer Dicke von 100 nm aus n-dotiertem Silizium mit einer Dotierstoffkonzentration von 5 x 10¹⁹ cm⁻³ gebildet. Als Dotierstoff wird für n-dotiertes Silizium Arsen oder Phosphor und für p-dotiertes Silizium Bor verwendet (siehe Figur 1).

Auf die dritte Siliziumschicht 4 wird eine erste Hilfsschicht 5 aufgebracht. Die erste Hilfsschicht 5 wird aus Siliziumnitrid in einer Dicke von 200 nm gebildet.

Unter Verwendung photolithographischer Prozeßschritte werden die erste Hilfsschicht 5, die dritte Siliziumschicht 4, die zweite Siliziumschicht 3 und die erste Siliziumschicht 2 anschließend durch anisotropes Trockenätzen zum Beispiel mit CHF₃, O₂ (für Nitrid) bzw. HBr, NF₃, He, O₂ (für Silizium) strukturiert. Dabei bildet sich eine Mesastruktur 6 (siehe Figur 2). Bei der Strukturierung wird eine Lithographie verwendet mit einem lithographischen Minimalmaß von F = 0,6 µm und einer maximalen Dejustierung von 0,2 µm. Die Ätzung wird um etwa 100 nm ins Substrat 1 überzogen, so daß auch die erste Siliziumschicht 2 außerhalb der Mesastruktur 6 entfernt wird. Die Mesastruktur 6 weist parallel zur Oberfläche des Substrats 1 einen Querschnitt von F x F auf.

Bei der Bildung der Mesastruktur 6 wird aus der ersten Siliziumschicht 2 ein unteres Source-/Draingebiet 2', aus der zweiten Siliziumschicht 3 ein Kanalgebiet 3' und aus der dritten Siliziumschicht 4 ein oberes Source-/Draingebiet 4'.

Die Seitenwände der Mesastruktur 6 werden anschließend mit einem 50 nm dicken SiO₂-Spacer 7 versehen. Durch Implantation zum Beispiel mit Arsen mit einer Dosis von 5 x 10¹⁵ cm⁻² und einer Energie von 40 keV wird seitlich der Mesastruktur 6 ein die Mesastruktur ringförmig umgebendes Anschlußgebiet 8 im Halbleitersubstrat 1 gebildet (siehe Figur 2).

Nach Entfernen der SiO₂-Spacer 7 wird ganzflächig eine isolierende Schicht 9 aus SiO₂ mit im wesentlichen konformer Kantenbedeckung aufgebracht (siehe Figur 3). Die isolierende Schicht 9 wird in einer Dicke gebildet, die der Höhe der Mesastruktur 6, die das untere Source-/Draingebiet 2', das Kanalgebiet 3' und das obere Source-/Draingebiet 4' umfaßt, entspricht. Die Dicke der isolierenden Schicht 9 beträgt daher zum Beispiel 500 nm.

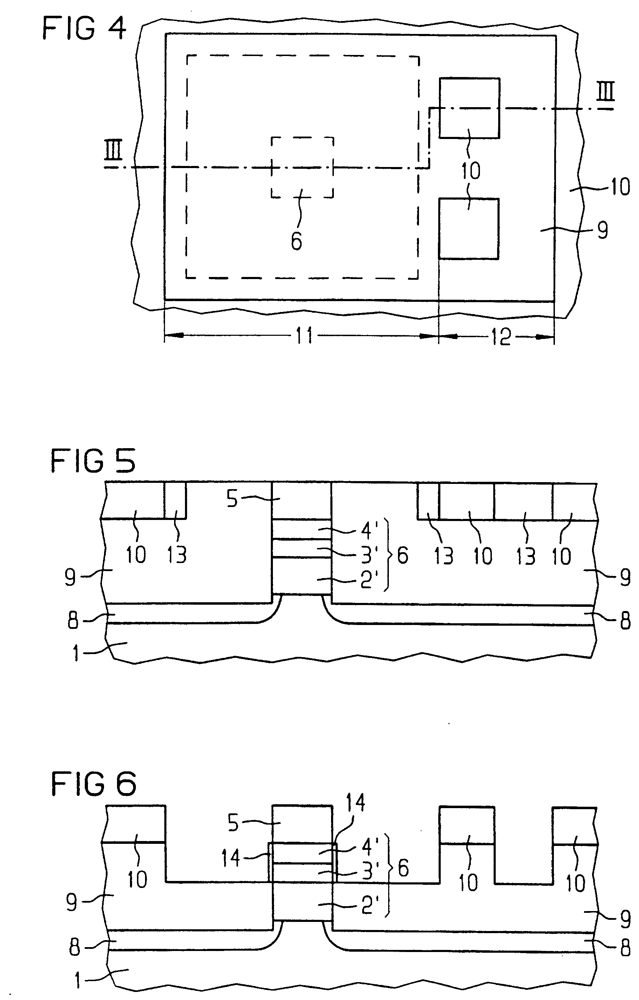

Anschließend wird eine zweite Hilfsschicht 10 aus Si₃N₄ aufgebracht und selektiv zu SiO₂ strukturiert. Die zweite Hilfsschicht 10 weist im wesentlichen dieselbe Dicke wie die erste Hilfsschicht 5, das heißt zum Beispiel 200 nm auf. Die Strukturierung der zweiten Hilfsschicht 10 erfolgt so, daß die Oberfläche der isolierenden Schicht 9 in einem ersten Bereich 11 freigelegt wird, der die Mesastruktur 6 seitlich überlappt und dessen laterale Abmessungen mindestens um das Doppelte der Schichtdicke der isolierenden Schicht 9 größer ist als die entsprechende laterale Abmessung der Mesastruktur 6. Die Oberfläche der isolierenden Schicht 9 wird ferner in einem zweiten Bereich 12 freigelegt, der an den ersten Bereich 11 angrenzt. In dem zweiten Bereich 12 verbleiben bei der Strukturierung der zweiten Hilfsschicht 10 inselförmige Teile der zweiten Hilfsschicht 10 (siehe Figur 3 und die in Figur 4 dargestellte Aufsicht auf Figur 3, wobei der erste Bereich 11 und der zweite Bereich 12 jeweils als Doppelpfeil mit dem entsprechenden Bezugszeichen gekennzeichnet sind). Der in Figur 3 dargestellte Schnitt durch Figur 4 ist in Figur 4 mit III-III bezeichnet. Als gestrichelte Linie ist in Figur 4 der Bereich eingezeichnet, in dem die Topologie der isolierenden Schicht 9 wegen der darunter angeordneten Mesastruktur 6 verändert ist. Ferner ist der in der Aufsicht nicht sichtbare Querschnitt der Mesastruktur 6 als gestrichelte Linie eingezeichnet.

Anschließend wird die isolierende Schicht 9 durch chemisch-mechanisches Polieren planarisiert. Dabei werden diejenigen Teile der isolierenden Schicht 9, die oberhalb der ersten Hilfsschicht 5 angeordnet, sind entfernt. Die erste Hilfsschicht 5 und die zweite Hilfsschicht 10 aus Siliziumnitrid wirken dabei als Ätzstop. Daher endet der Schichtabtrag der isolierenden Schicht 9, sobald die Oberfläche der ersten Hilfsschicht 5 bzw. der zweiten Hilfsschicht 10 erreicht ist (siehe Figur 5). Zwischen den Teilen der zweiten Hilfsschicht 10 und der isolierenden Schicht 9 verbliebene Lücken werden anschließend durch konforme Abscheidung und Strukturierung einer SiO₂-Schicht mit einer isolierenden Füllung 13 aufgefüllt.

Unter Verwendung der ersten Hilfsschicht 5 und der zweiten Hilfsschicht 10 als Ätzmaske wird anschließend die isolierende Schicht 9 und die isolierende Füllung 13 geätzt. Die Ätzung erfolgt zum Beispiel mit C₄F₈ selektiv zu Siliziumnitrid. Dabei wird über die Ätzzeit die Tiefe der Ätzung bestimmt. Die isolierende Schicht 9 wird soweit geätzt, daß die Seitenwände des oberen Source-/Draingebietes 4' und des Kanalgebietes 3' freigelegt werden (siehe Figur 6). Die Seitenwände des unteren Source-/Draingebietes 2' bleiben dagegen von der isolierenden Schicht 9 bedeckt. Durch thermische Oxidation wird an den freigelegten Seitenwänden des Kanalgebietes 3' und des oberen Source-/Draingebietes 4' nachfolgend ein Gatedielektrikum 14 aus zum Beispiel SiO₂ in einer Schichtdicke von zum Beispiel 5 nm gebildet.

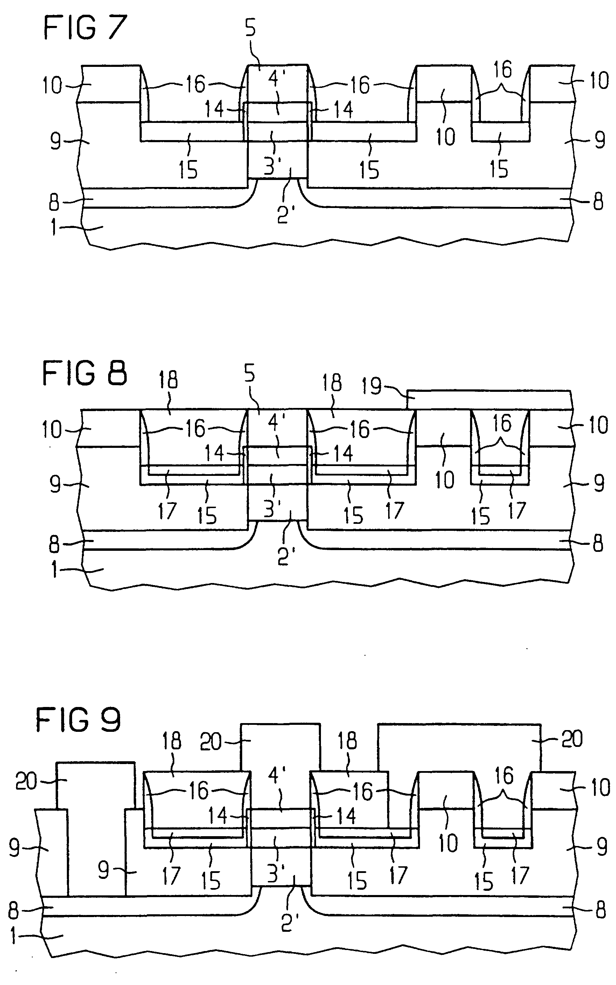

In der bei der Ätzung der isolierenden Schicht 9 entstandene Öffnung wird anschließend durch Abscheidung einer zum Beispiel 400 nm dicken n-dotierten Polysiliziumschicht und anschließendes Planarisieren mit Hilfe von chemischmechanischem Polieren und anisotropes Rückätzen mit HBr, Cl₂, He, O₂ der Polysiliziumschicht eine Gateelektrode 15 gebildet. Die Gateelektrode 15 bedeckt den gesamten Boden der besagten Öffnung. Sie weist eine Höhe entsprechend der Höhe des Kanalgebietes 3' von zum Beispiel 100 nm auf (siehe Figur 7).

Bei der Planarisierung der dotierten Polysiliziumschicht dienen die erste Hilfsschicht 5 und die zweite Hilfsschicht 10, die jeweils Siliziumnitrid enthalten, wiederum als definierter Ätzstopp. Dadurch ist die genaue Einstellung der Höhe der Gateelektrode 15 auf eine der Kanallänge entsprechende Dicke von zum Beispiel 100 nm über die Dauer der anisotropen Ätzung möglich.

An den Flanken der Öffnung, in der die Gateelektrode 15 gebildet wurde, werden anschließend isolierende Spacer 16 zum Beispiel aus SiO₂ gebildet. Die isolierenden Spacer 16 werden durch konforme Abscheidung einer 50 nm dicken SiO₂-Schicht und anschließendes anisotropes Rückätzen selektiv zu Silizium und Siliziumnitrid, zum Beispiel mit CHF₃, O₂ gebildet.

Die Gateelektrode 15 wird anschließend durch selbstjustierte Silizierung mit einem Silizidanschluß 17 versehen (siehe Figur 8). Dazu wird zum Beispiel ganzflächig eine Titanschicht aufgebracht, die in einem nachfolgenden Temperprozeß mit dem darunter angeordneten Silizium der Gateelektrode 15 den Silizidanschluß 17 bildet. Mit Siliziumnitrid oder Siliziumoxid reagiert das Titan dagegen nicht, so daß es selektiv zum Silizidanschluß 17 anschließend entfernt werden kann.

Der Bereich oberhalb des Silizidanschlusses 17 zwischen den isolierenden Spacern 16 wird anschließend mit einer isolierenden Füllung 18 zum Beispiel aus SiO₂ versehen. Die isolierende Füllung 18 schließt in der Höhe mit der ersten Hilfsschicht 5 und der zweiten Hilfsschicht 10 ab (siehe Figur 8). Zur Bildung der isolierenden Füllung 18 wird ganzflächig eine weitere isolierende Schicht in einer Dicke von zum Beispiel 300 nm abgeschieden. Durch Planarisierung mittels chemischmechanischem Polieren wird daraus die isolierende Füllung 18 gebildet. Die erste Hilfsschicht 5 und die zweite Hilfsschicht 10 wirken wiederum als Ätzstopp.

Es wird eine dritte Hilfsschicht 19 zum Beispiel aus Polysilizium in einer Dicke von 100 nm aufgebracht und so strukturiert, daß die dritte Hilfsschicht 19 die zweite Hilfsschicht 10 im zweiten Bereich 12 abdeckt (siehe Figur 4 und Figur 8).

Anschließend werden die erste Hilfsschicht 5 und die zweite Hilfsschicht 10, soweit sie nicht von der dritten Hilfsschicht 19 abgedeckt ist, selektiv zu SiO₂ und Silizium zum Beispiel mit heißer H₃PO₄ entfernt. Dabei wird die Oberfläche des oberen Source-/Draingebietes 4' freigelegt. Mit anderen Worten öffnet sich ein Kontakt zum oberen Source-/Draingebiet 4' selbstjustiert.

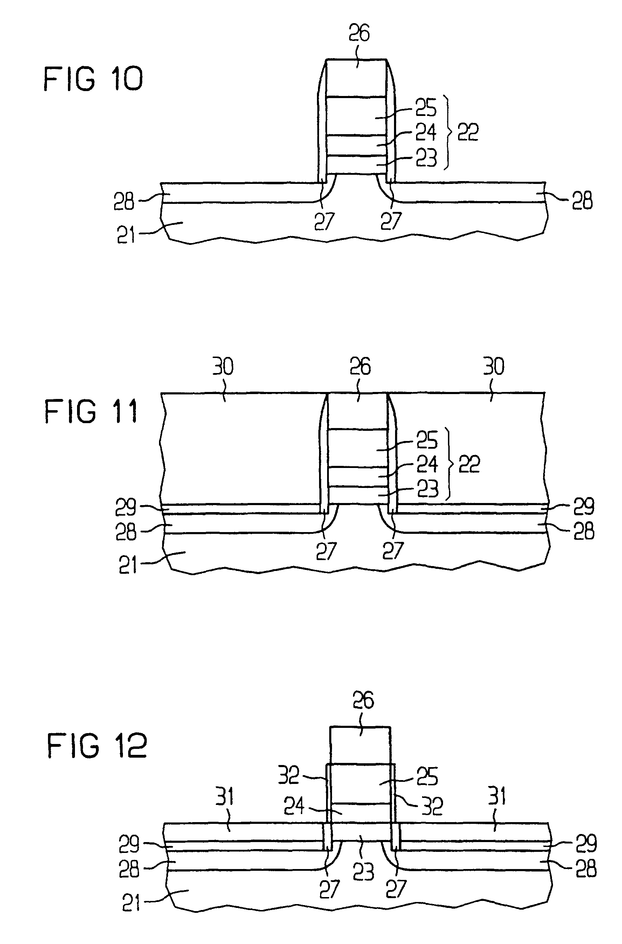

Nach Entfernen der dritten Hilfsschicht 19 werden unter Verwendung photolithographischer Prozeßschritte Kontaktlöcher zu dem Anschlußgebiet 8 sowie zu dem Silizidanschluß 17 der Gateelektrode 15 geöffnet. Es werden Kontakte 20 zu dem Anschlußgebiet 8, dem oberen Source-/Draingebiet 4' und dem Anschlußgebiet 17 der Gateelektrode 15 durch Bildung und Strukturierung einer Metallschicht, vorzugsweise aus Al Si (1 Prozent) Cu (0,5 Prozent), gebildet (siehe Figur 9). Bei der Öffnung des Kontaktloches zum Silizidanschluß 17 der Gateelektrode 15 verhindert der im zweiten Bereich verbliebene Teil der zweiten Hilfsschicht 10, daß der unter den Inseln der zweiten Hilfsschicht 10 angeordnete Teil der isolierenden Schicht 9 durchgeätzt wird. Da dieser Teil der isolierenden Schicht 9 dieselbe Dicke aufweist, wie die isolierende Schicht 9 in dem Bereich, in dem das Kontaktloch zum Anschlußgebiet 8 gebildet wird, wird dadurch ein Kurzschluß zwischen der Gatelektrode 15 und dem Anschlußgebiet 8 vermieden. Das Vorsehen der Inseln im Bereich des Kontaktes 20 zur Gateelektrode 15 ermöglicht auch bei Abmessungen der Mesastruktur 6 und der Inseln im Bereich des lithographischen Minimalmaßes F ein größeres Kontaktloch. Somit kann der Querschnitt des Kontaktes zur Gateelektrode 15 bezüglich seiner elektrischen Eigenschaften optimiert werden.

Wird der Prozeß so genau geführt, daß ein Kurzschluß zwischen der Gateelektrode 15 und dem Anschlußegebiet 8 nicht zu befürchten ist, kann die Verwendung der dritten Hilfsschicht 19, die die zweite Hilfsschicht 10 im Bereich des Kontaktes zur Gateelektrode 15 schützt, entfallen.

In einem weiteren Ausführungsbeispiel wird auf einem Substrat 21, zum Beispiel einer monokristallinen Siliziumscheibe oder der monokristallinen Siliziumschicht eines SOI-Substrates, eine Mesastruktur 22 gebildet, die ein unteres Source/Draingebiet 23, ein Kanalgebiet 24 und ein oberes Source/Draingebiet 25 in vertikaler Aufeinanderfolge umfaßt. Das untere Source-/Draingebiet 23 weist n-dotiertes Silizium mit einer Dotierstoffkonzentration 5 x 10¹⁹ cm⁻³ und eine Dicke von 100 nm auf. Das Kanalgebiet 24 weist p-dotiertes Silizium mit einer Dotierstoffkonzentration von 10¹⁸ cm⁻³ und eine Dicke von 100 nm auf. Das obere Source-/Draingebiet 25 weist n-dotiertes Silizium mit einer Dotierstoffkonzentration von 5 x 10¹⁹ cm⁻³ und eine Dicke von 200 nm auf. Als Dotierstoff wird für n-dotiertes Silizium Arsen oder Phosphor und für p-dotiertes Silizium Bor verwendet (siehe Figur 10).

Zur Bildung der Mesastruktur 22 wird, analog wie im ersten Ausführungsbeispiel, eine Halbleiterschichtenfolge mit einer ersten Siliziumschicht, die n-dotiert ist, einer zweiten Siliziumschicht, die p-dotiert ist und einer dritten Siliziumschicht, die n-dotiert ist durch Epitaxie mit Si₂H₂Cl₂, B₂H₆, AsH₃, PH₃, HCl, H₂ aufgewachsen. Alternativ wird die Halbleiterschichtenfolge durch Implantation und Ausheilen gebildet. Nach Aufbringen einer Hilfsschicht 26 werden die Schichtenfolge und die Hilfsschicht 26 zur Bildung der Mesastruktur 22 durch anisotropes Ätzen strukturiert. Die Mesastruktur 22 wird mit im wesentlichen quadratischem Querschnitt mit einer Kantenlänge von 0,6 µm gebildet. Die verwendete Lithographie weist dabei ein lithographisches Minimalmaß von F = 0,6 µm und eine Dejustierung von maximal 0,2 µm auf.

Die anisotrope Ätzung zur Bildung der Mesastruktur 22 wird soweit fortgesetzt, daß auch die dritte Siliziumschicht bei der Bildung des unteren Source-/Draingebietes 23 sicher durchtrennt wird. Die anisotrope Ätzung wirkt zum Beispiel mit CHF₃, O₂ (für Nitrid) bzw. HBr, NF₃, He, O₂ (für Silizium).

Die Flanken der Mesastruktur 22 werden anschließend mit SiO₂-Spacern 27 versehen (siehe Figur 10). Die SiO₂-Spacer 27 werden zum Beispiel durch Abscheidung einer SiO₂-Schicht in einer Dicke von 50 nm und anschließendes anisotropes Rückätzen gebildet. Zur Bildung eines Anschlußgebietes 28 für das untere Source-/Draingebiet 23 wird nachfolgend eine Implantation mit Arsen bei 40 keV und 5 x10¹⁵ cm⁻² durchgeführt. Durch eine Temperung bei zum Beispiel 1000°C während 10 Sekunden wird der Dotierstoff aktiviert. An der Oberfläche des Anschlußgebietes 28 wird nachfolgend durch selbstjustierte Silizidbildung ein Silizidanschluß 29 gebildet. Der Silizidanschluß 29 wird zum Beispiel aus TiSi₂ gebildet. Er dient der Reduktion der Serienwiderstände des Anschlußgebietes 28 und des unteren Source-/Draingebietes 23. Das Anschlußgebiet 28 umgibt die Mesastruktur 22 ringförmig.

Anschließend wird ganzflächig eine isolierende Schicht 30 aufgebracht, deren Dicke größer ist als die Gesamthöhe der Mesastruktur 22 und der Hilfsschicht 26. Die isolierende Schicht 30 weist zum Beispiel eine Dicke von 600 nm auf. Durch chemisch-mechanisches Polieren wird die isolierende Schicht 30 planarisiert. Dabei wirkt die Hilfsschicht 26 aus Siliziumnitrid als Ätzstop (siehe Figur 11).

Selektiv zu Nitrid wird die isolierende Schicht 30 soweit geätzt, daß eine Isolationsstruktur 31 entsteht, die in der Höhe mit der Höhe des unteren Source-/Draingebietes 23 abschließt (siehe Figur 12). Diese Ätzung wird zum Beispiel naßchemisch mit NHF₄, HF durchgeführt. Da die isolierende Schicht 30 nach der Planarisierung in der Höhe mit der Hilfsschicht 26 abschließt und durch chemisch-mechanisches Polieren planarisiert wurde, ist die Tiefe der Ätzung bei der Bildung der Isolationsstruktur 31 über die Ätzzeit genau kontrollierbar. Dabei werden die Flanken des Kanalgebietes 24 und des oberen Source-/Draingebietes 25 freigelegt.

An den Flanken des Kanalgebietes 24 und des oberen Source/Draingebietes 25 wird nachfolgend durch thermische Oxidation ein Gatedielektrikum 32 gebildet, das eine Dicke von zum Beispiel 5 nm aufweist (siehe Figur 12).

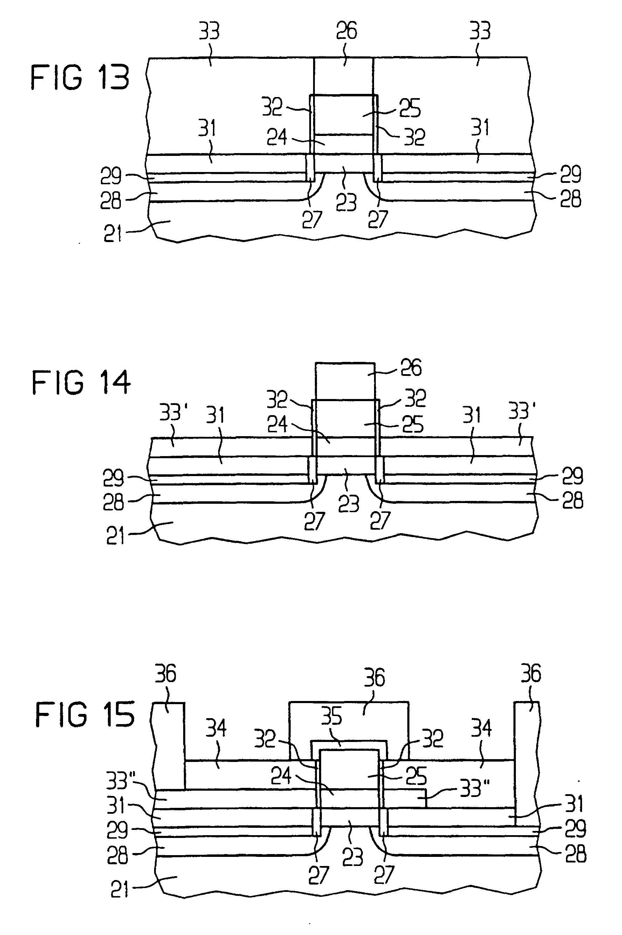

Nachfolgend wird eine dotierte Polysiliziumschicht 33 erzeugt. Die dotierte Polysiliziumschicht 33 weist eine Dicke auf, die mindestens der Summe der Dicken des Kanalgebietes 24, des oberen Source-/Draingebietes 25 sowie der Hilfsschicht 26 entspricht. Das heißt, die dotierte Polysiliziumschicht 33 weist eine Dicke von zum Beispiel 500 nm auf. Durch chemisch-mechanisches Polieren wird die dotierte Polysiliziumschicht 33 planarisiert. Dabei wirkt die Hilfsschicht 26 als Ätzstopp. Durch eine Ätzung mit HBr, Cl₂, He, O₂ selektiv zu Siliziumnitrid und Siliziumoxid wird die dotierte Polysiliziumschicht 33 zurückgeätzt. Dabei wird eine Gateelektrodenschicht 33' gebildet, deren Höhe der Höhe des Kanalgebietes 24 entspricht. Das heißt, die Gateelektrodenschicht 33' weist eine Höhe von 100 nm auf (siehe Figur 14).

Unter Einsatz photolithographischer Prozeßschritte wird die Gateelektrodenschicht 33' strukturiert, wobei eine seitlich begrenzte Gateelektrode 33'' gebildet wird. Je nach Justierung der dabei verwendeten Photolackmaske umgibt die Gateelektrode 33'' die Mesastruktur 22 dabei ringförmig oder ist nur entlang einem Teil der Flanken der Mesastruktur 22 angeordnet. Durch eine solche Überlappung der Photolackmaske mit der Mesastruktur 22 kann die Transistorweite unter die minimale Strukturgröße F gesenkt werden.

Die Gateelektrode 33'' wird mit einer weiteren Isolationsstruktur 34 abgedeckt. Der Bildung der weiteren Isolationsstruktur 34 wird eine weitere Isolationsschicht aus zum Beispiel SiO₂ gebildet, die die Mesastruktur 22 und die Hilfsschicht 26 überragt. Durch Planarisieren und Rückätzen der weiteren Isolationsschicht wird die weitere Isolationsstruktur 34 gebildet. Anschließend wird selektiv zu SiO₂ und Silizium die Hilfsschicht 26 zum Beispiel mit heißer H₃PO₄ entfernt. Dabei wird die Oberfläche des oberen Source/Draingebietes 25 freigelegt (siehe Figur 15). Die freigelegte Oberfläche des oberen Source-/Draingebietes 25 wird mit einem Silizidanschlußgebiet 35 aus zum Beispiel TiSi₂ versehen. Das Silizidanschlußgebiet 35 wird zum Beispiel in einem selbstjustierten Silizidierungsprozeß aus Titan gebildet. Zu dem Silizidanschluß 29 des Anschlußgebietes 28 und zu der Gateelektrode 33'' werden in der weiteren Isolationsstruktur 34 bzw. in der weiteren Isolationsstruktur 34 und der Isolationsstruktur 31 Kontaktlöcher geöffnet und mit Kontakten 36 versehen. Ein Kontakt 36 wird zu dem Silizidanschluß 35 des oberen Source-/Draingebietes 25 gebildet.

## Patentansprüche

1. Verfahren zur Herstellung eines vertikalen MOS-Transistors,
- bei dem auf einer Hauptfläche eines Halbleitersubstrats (1; 21) durch Aufbringen und Strukturieren einer Halbleiterschichtenfolge eine Mesastruktur (6; 22) gebildet wird, die ein unteres Source-/Draingebiet (2'; 23), ein Kanalgebiet (3'; 24) und ein oberes Source-/Draingebiet (4'; 25) aufweist,
- bei dem auf die Halbleiterschichtenfolge eine erste Hilfsschicht (5; 26) aufgebracht wird, die gemeinsam mit der Halbleiterschichtenfolge strukturiert wird,
- bei dem seitlich der Mesastruktur (6; 22) im Halbleitersubstrat (1) ein Anschlußgebiet (8; 28) für das untere Source/Draingebiet (2'; 23) gebildet wird,
- bei dem eine Isolationsstruktur gebildet wird, die mindestens die Seitenwand des unteren Source-/Draingebietes (2'; 23) im wesentlichen bedeckt, und
- bei dem an der Seitenwand des Kanalgebiets (3'; 24) ein Gatedielektrikum (14; 32) und eine Gateelektrode (15; 33'') gebildet werden, deren Höhe im wesentlichen gleich der Höhe des Kanalgebietes (3'; 24) ist,
**dadurch gekennzeichnet, dass**
- zur Bildung der Isolationsstruktur eine isolierende Schicht (9; 30) aufgebracht wird, deren Dicke größer oder gleich der Dicke der Halbleiterschichtenfolge (2', 3', 4'; 23, 24, 25) ist und die durch chemisch-mechanisches Polieren bis auf die Höhe der ersten Hilfsschicht (5; 26) planarisiert wird, wobei die erste Hilfsschicht (5; 26) als Ätzstopp wirkt und weitere Ätzschritte durchgeführt werden, bei denen die Seitenwand des Kanalgebiets (3'; 24) freigelegt wird.

2. Verfahren nach Anspruch 1,
**dadurch gekennzeichnet, dass**
zur Bildung des Anschlußgebietes (8; 28) eine Implantation durchgeführt wird, bei der die Flanken der Mesastruktur (6; 22) mit einem maskierenden Spacer (7; 27) bedeckt sind.

3. Verfahren nach Anspruch 1 oder 2,
**dadurch gekennzeichnet, dass**
die isolierende Schicht (9) mit im wesentlichen konformer Kantenbedeckung aufgebracht wird und ihre Dicke im wesentlichen gleich der Dicke der Halbleiterschichtenfolge (2', 3', 4') ist,
eine zweite Hilfsschicht (10) aufgebracht wird, die dieselben Ätzeigenschaften und im wesentlichen die gleiche Dicke wie die erste Hilfsschicht (5) aufweist,
die zweite Hilfsschicht (10) so strukturiert wird, daß die Oberfläche der isolierenden Schicht (9) mindestens in einem ersten Bereich (11) freigelegt wird, der die Mesastruktur (6) seitlich überlappt und dessen laterale Abmessungen jeweils mindestens um das Doppelte der Schichtdicke der isolierenden Schicht (9) größer ist als die entsprechende laterale Abmessung der Mesastruktur (6),
durch chemisch-mechanisches Polieren der isolierenden Schicht (9) die Oberfläche der ersten Hilfsschicht (5) und der zweiten Hilfsschicht (10) freigelegt wird,
zwischen Teilen der zweiten Hilfsschicht (10) und der isolierenden Schicht (9) verbliebene Lücken mit einer isolierenden Füllung (13) aufgefüllt werden,
unter Verwendung der ersten Hilfsschicht (5) und der zweiten Hilfsschicht (10) als Maske die isolierende Schicht (9) soweit geätzt wird, daß die Seitenwand des Kanalgebietes (3') im wesentlichen freigelegt wird,
an der Seitenwand des Kanalgebietes (3') ein Gatedielektrikum (14) gebildet wird,
eine leitfähige Schicht erzeugt wird, die den Zwischenraum zwischen der isolierenden Schicht (9) und der Mesastruktur (6) im wesentlichen auffüllt, und
die Gateelektrode (15) durch Rückätzen der leitfähigen Schicht gebildet wird.

4. Verfahren nach Anspruch 3,
**dadurch gekennzeichnet, dass**
die Oberfläche der isolierenden Schicht (9) bei der Strukturierung der zweiten Hilfsschicht (10) zusätzlich in einem zweiten Bereich (12) freigelegt wird, der an den ersten Bereich (11) angrenzt,
beim Freilegen der Seitenwand des Kanalgebietes (3') die isolierende Schicht (9) auch im zweiten Bereich (12) geätzt wird, so dass im ersten Bereich (11) und im zweiten Bereich (12) eine zusammenhängende Öffnung entsteht,
die Öffnung mit der leitfähigen Schicht im wesentlichen aufgefüllt wird,
nach der Bildung der Gateelektrode (15) der erste Bereich (11) und der zweite Bereich (12) mit einer isolierenden Füllung (18) versehen wird,
die erste Hilfsschicht (5) und die zweite Hilfsschicht (10) selektiv zur isolierenden Schicht (9) und zur isolierenden Füllung (18) entfernt werden, wobei die Oberfläche des oberen Source-/Draingebietes (4') freigelegt wird, und
in dem zweiten Bereich (12) ein Kontaktloch zu der Gateelektrode (15) geöffnet wird.

5. Verfahren nach Anspruch 4,
**dadurch gekennzeichnet, dass**
vor dem Entfernen der ersten Hilfsschicht (5) und der zweiten Hilfsschicht (10) ein dritte Hilfsschicht (19) aufgebracht wird, zu der die erste Hilfsschicht (5) und die zweite Hilfsschicht (10) selektiv ätzbar sind und die so strukturiert wird, dass die erste Hilfsschicht (5) freigelegt wird und dass der zweite Bereich (12) von der dritten Hilfsschicht (19) bedeckt ist.

6. Verfahren nach einem der Ansprüche 3 bis 5,
**dadurch gekennzeichnet, dass**
die erste Hilfsschicht (5) und die zweite Hilfsschicht (10) Siliziumnitrid aufweisen,
die dritte Hilfsschicht (19) Polysilizium aufweist,
die isolierende Schicht (9) und die isolierende Füllung (18) Siliziumoxid enthalten, und
die leitfähige Schicht dotiertes Polysilizium enthält.

7. Verfahren nach Anspruch 6,
**dadurch gekennzeichnet, dass**
die Oberfläche des Anschlußgebietes (8) und/oder der Gateelektrode (15) und/oder des oberen Source-/Draingebietes (4') mit Metallsilizid versehen wird.

8. Verfahren nach Anspruch 1 oder 2,
**dadurch gekennzeichnet, dass**
die isolierende Schicht (9; 30) durch chemisch-mechanisches Polieren und Ätzen strukturiert wird, so dass die Isolationsstruktur gebildet wird, die seitlich der Mesastruktur (6; 22) angeordnet ist und deren Dicke im wesentlichen gleich der Höhe des unteren Source-/Draingebietes (2'; 23) ist,
die Seitenwand des Kanalgebietes (3'; 24) freigelegt und mit einem Gatedielektrikum (14; 32) versehen wird,
zur Bildung der Gateelektrode (15; 33'') eine leitfähige Schicht abgeschieden und strukturiert wird,
eine weitere isolierende Schicht (18; 34) aufgebracht wird, die die Gateelektrode (15; 33'') bedeckt, und
Kontakte zu dem Anschlußgebiet (8; 28), der Gateelektrode (15; 33'') und dem oberen Source-/Draingebiet (4'; 25) gebildet werden.

9. Verfahren nach Anspruch 8,
**dadurch gekennzeichnet, dass**
die isolierende Schicht (9; 30), die weitere isolierende Schicht (18; 34) und/oder die isolierende Füllung Siliziumoxid enthalten,
die erste Hilfsschicht (5; 26) Siliziumnitrid enthält, und
die leitfähige Schicht dotiertes Polysilizium enthält.

10. Verfahren nach Anspruch 9,
**dadurch gekennzeichnet, dass** die Oberfläche des Anschlußgebietes (8; 28) und/oder der Gateelektrode (15; 33'') und/oder des oberen Source-/Draingebietes (4'; 25) mit Metallsilizid versehen wird.

## Claims

1. Method for the production of a vertical MOS transistor,
- in which a mesa structure (6; 22), which has a lower source/drain region (2'; 23), a channel region (3'; 24) and an upper source/drain region (4'; 25), is formed by applying a semiconductor layer sequence to a main surface of a semiconductor substrate (1; 21) and structuring this sequence,
- in which a first auxiliary layer (5; 26), which is structured together with the semiconductor layer sequence, is applied to the semiconductor layer sequence,
- in which a terminal region (8; 28) for the lower source/drain region (2'; 23) is formed laterally with respect to the mesa structure (6; 22) in the semiconductor substrate (1),
- in which an insulation structure is formed which essentially covers at least the side wall of the lower source/drain region (2'; 23), and
- in which a gate dielectric (14; 32) and a gate electrode (15; 33'') whose height is essentially equal to the height of the channel region (3'; 24) are formed on the side wall of the channel region (3'; 24),
**characterized in that**,
- in order to form the insulation structure, an insulating layer (9; 30) is applied whose thickness is greater than or equal to the thickness of the semiconductor layer sequence (2', 3', 4'; 23, 24, 25) and which is planarized by chemical mechanical polishing to the level of the first auxiliary layer (5; 26), the first auxiliary layer (5; 26) acting as an etching stop and further etching steps being carried out, in which the side wall of the channel region (3'; 24) is uncovered.

2. Method according to Claim 1, **characterized in that**, in order to form the terminal region (8; 28), implantation is carried out in which the flanks of the mesa structure (6; 22) are covered with a masking spacer (7; 27).

3. Method according to Claim 1 or 2,
**characterized in that** the insulating layer (9) is applied with essentially conformal edge coverage and its thickness is essentially equal to the thickness of the semiconductor layer sequence (2', 3', 4'),
a second auxiliary layer (10) is applied which has the same etching properties and essentially the same thickness as the first auxiliary layer (5),
the second auxiliary layer (10) is structured in such a way that the surface of the insulating layer (9) is uncovered at least in a first area (11) which laterally overlaps the mesa structure (6) and whose lateral dimensions is [sic] respectively greater by at least twice the layer thickness of the insulating layer (9) than the corresponding lateral dimension of the mesa structure (6),
the surface of the first auxiliary layer (5) and of the second auxiliary layer (10) is uncovered by chemical mechanical polishing of the insulating layer (9),
gaps that have remained between parts of the second auxiliary layer (10) and the insulating layer (9) are filled with an insulating filling (13),
using the first auxiliary layer (5) and the second auxiliary layer (10) as mask, the insulating layer (9) is etched to such an extent that the side wall of the channel region (3') is essentially uncovered,
a gate dielectric (14) is formed on the side wall of the channel region (3'),
a conductive layer is produced which essentially fills the intermediate space between the insulating layer (9) and the mesa structure (6),
the gate electrode (15) is formed by etching back the conductive layer.

4. Method according to Claim 3,
**characterized in that**, during the structuring of the second auxiliary layer (10), the surface of the insulating layer (9) is additionally uncovered in a second area (12) which adjoins the first area (11),
when the side wall of the channel region (3') is being uncovered, the insulating layer (9) is also etched in the second area (12), so that a continuous opening is produced in the first area (11) and in the second area (12),
the opening is essentially filled with the conductive layer,
after the gate electrode (15) has been formed, the first area (11) and the second area (12) are provided with an insulating filling (18),
the first auxiliary layer (5) and the second auxiliary layer (10) are removed selectively with respect to the insulating layer (9) and with respect to the insulating filling (18), the surface of the upper source/drain region (4') being uncovered, and
a contact hole is opened to the gate electrode (15) in the second area (12).

5. Method according to Claim 4, **characterized in that**, before the first auxiliary layer (5) and the second auxiliary layer (10) are removed, a third auxiliary layer (19) is applied, with respect to which the first auxiliary layer (5) and the second auxiliary layer (10) can be etched selectively, and which is structured in such a way that the first auxiliary layer (5) is uncovered and the second area (12) is covered by the third auxiliary layer (19).

6. Method according to one of Claims 3 to 5,
**characterized in that** the first auxiliary layer (5) and the second auxiliary layer (10) comprise silicon nitride,
the third auxiliary layer (19) comprises polysilicon,
the insulating layer (9) and the insulating filling (18) contain silicon oxide, and
the conductive layer contains doped polysilicon.

7. Method according to Claim 6, **characterized in that** the surface of the terminal region (8) and/or of the gate electrode (15) and/or of the upper source/drain region (4') is provided with metal silicide.

8. Method according to Claim 1 or 2,
**characterized in that** the insulating layer (9; 30) is structured by chemical mechanical polishing and etching so as to form the insulation structure which is arranged laterally with respect to the mesa structure (6; 22) and whose thickness is essentially equal to the height of the lower source/drain region (2'; 23),
the side wall of the channel region (3'; 24) is uncovered and provided with a gate dielectric (14; 32),
a conductive layer is deposited and structured in order to form the gate electrode (15; 33''),
a further insulating layer (18; 34) is applied which covers the gate electrode (15; 33''), and
contacts are formed to the terminal region (8; 28), the gate electrode (15; 33'') and the upper source/drain region (4'; 25).

9. Method according to Claim 8,
**characterized in that** the insulating layer (9; 30), the further insulating layer (18; 34) and/or the insulating filling contain silicon oxide,
the first auxiliary layer (5; 26) contains silicon nitride, and
the conductive layer contains doped polysilicon.

10. Method according to Claim 9, **characterized in that** the surface of the terminal region (8; 28) and/or of the gate electrode (15; 33'') and/or of the upper source/drain region (4'; 25) is provided with metal silicide.

## Revendications

1. Procédé de production d'un transistor MOS vertical,
- dans lequel on forme sur une surface principale d'un substrat (1, 21) semiconducteur par dépôt et structuration d'une succession de couches semiconductrices, une structure (6 ; 22) mésa qui comporte une zone (2'; 23) inférieure de source/drain, une zone (3'; 24) de canal et une zone (4' ; 25) supérieure de source/drain,
- dans lequel on dépose sur la succession de couches semiconductrices, une première couche (5 ; 26) auxiliaire que l'on structure conjointement avec la succession de couches semiconductrices,
- dans lequel on forme latéralement à la structure (6 ; 22) mésa, dans le substrat (1) semiconducteur, une zone (8 ; 28) de connexion pour la zone (2' ; 23) inférieure de source/drain,
- dans lequel on forme une structure d'isolement, qui recouvre sensiblement au moins la paroi latérale de la zone (2'; 23) inférieure de source/drain, et
- dans lequel on forme sur la paroi latérale de la zone (3'; 24) de canal un diélectrique (14 ; 32) de grille et une électrode (15 ; 33") de grille, dont la hauteur est sensiblement égale à la hauteur (3' ; 24) de canal,
**caractérisé en ce que**,
- pour former la structure d'isolement, on dépose une couche (9 ; 30) isolante dont l'épaisseur est supérieure ou égale à l'épaisseur de la succession (2', 3', 4'; 23, 24, 25) de couches semiconductrices et qui est planarisée par polissage chimiomécanique, jusqu'au niveau de la première couche (5 ; 26) auxiliaire, la première couche (5 ; 26) auxiliaire servant d'arrêt d'attaque et on effectue d'autres stades d'attaque dans lesquels la paroi latérale de la zone (3' ; 24) de canal est mise à nu.

2. Procédé suivant la revendication 1, **caractérisé en ce que** pour former la zone (8 ; 28) de connexion, on effectue une implantation dans laquelle les flancs de la structure (6 ; 22) mésa sont recouverts d'un espaceur (7 ; 27) de masquage.

3. Procédé suivant la revendication 1 ou 2, **caractérisé en ce que** l'on dépose la couche (9) d'isolement avec un recouvrement d'arête sensiblement conforme, et son épaisseur est sensiblement égale à l'épaisseur de la succession (2', 3', 4') de couches semiconductrices,
on dépose une deuxième couche (10) auxiliaire, qui a les mêmes propriétés d'attaque et sensiblement la même épaisseur que la première couche (5) auxiliaire,
on structure la deuxième couche (10) auxiliaire, de façon à mettre à nu la surface de la couche (9) isolante au moins dans une première zone (11), qui chevauche latéralement la structure (6) mésa et dont les dimensions latérales sont respectivement plus grandes, d'au moins du double de l'épaisseur de la couche (9) isolante, que la dimension latérale correspondante de la structure (6) mésa,
par polissage chimiomécanique de la couche (9) isolante, on met à nu la surface de la première couche (5) auxiliaire et de la deuxième couche (10) auxiliaire,
on remplit d'un garnissage (13) isolant les intervalles restant entre la deuxième couche (10) auxiliaire et la couche (9) isolante,
en utilisant la première couche (5) auxiliaire et la deuxième couche (10) auxiliaire comme masque, on attaque la couche (9) isolante si loin, que l'on met sensiblement à nu la paroi latérale de la zone (3') de canal,
on forme sur la paroi latérale de la zone (3') de canal un diélectrique (14) de grille,
on produit une couche conductrice qui remplit l'intervalle entre la couche (9) isolante et la structure (6) mésa et,
on forme l'électrode (15) de grille par attaque en retrait de la couche conductrice.

4. Procédé suivant la revendication 3, **caractérisé en ce que**
on met à nu la surface de la couche mince (9) isolante lors de la structuration de la deuxième couche (10) auxiliaire, en plus dans une deuxième zone (12) qui est adjacente à la première zone (11),
lors de la mise à nu de la paroi latérale de la zone (3') de canal, on attaque aussi la couche (9) isolante dans la deuxième zone (12), de façon à créer dans la première zone (11) et dans la deuxième zone (12) une ouverture d'un seul tenant,
on emplit sensiblement l'ouverture de la couche conductrice,
après la formation d'électrode (15) de grille, on munit la première zone (11) et la deuxième zone (12) d'un garnissage (18) isolant,
on élimine la première couche (5) auxiliaire et la deuxième couche (10) auxiliaire sélectivement par rapport à la couche (9) isolante et par rapport au garnissage isolant, en mettant à nu la surface de la zone (4') supérieure de source/drain, et
on ouvre dans la deuxième zone (12) un trou métallisé allant vers l'électrode (15) de grille.

5. Procédé suivant la revendication 4, **caractérisé en ce que**,
avant d'éliminer la première couche (5) auxiliaire et la deuxième couche (10) auxiliaire, on dépose une troisième couche (19) auxiliaire, par rapport à laquelle la première couche (5) auxiliaire et la deuxième couche (10) auxiliaire peuvent être attaquées de manière sélective et ont la structure, de façon à ce que la première couche (5) auxiliaire soit mise à nu et de façon à ce que la deuxième zone (12) soit recouverte de la troisième couche (19) auxiliaire.

6. Procédé suivant l'une des revendications 3 à 5, **caractérisé en ce que**,
la première couche (5) auxiliaire et la deuxième couche (10) auxiliaire comprennent du nitrure de silicium,
la troisième couche (19) auxiliaire comprend du polysilicium,
la couche (9) isolante et le garnissage (18) isolant contiennent de l'oxyde de silicium et,
la couche conductrice contient du polysilicium dopé.

7. Procédé suivant la revendication 6, **caractérisé en ce que** la surface de la zone (8) de connexion et/ou de l'électrode de grille et/ou de la zone (4') supérieure de source/drain, est munie de siliciure métallique.

8. Procédé suivant la revendication 1 ou 2, **caractérisé en ce que** l'on structure la couche (9 ; 30) isolante par polissage chimiomécanique et attaque, de façon à former la structure d'isolement qui est disposée latéralement à la structure (6 ; 22) mésa et dont l'épaisseur est sensiblement égale à la hauteur de la zone (2' ; 23) inférieure de source/drain,
on met à nu la paroi latérale de la zone (3'; 24) de canal, et on la munit d'un diélectrique (14 ; 32) de grille,
pour former l'électrode (15 ; 33") de grille, on dépose une couche conductrice sur la structure,
on dépose une autre couche (18 ; 34) isolante, qui recouvre l'électrode (15 ; 33") de grille, et
on forme des contacts allant à la zone (8 ; 28) de connexion à l'électrode (15 ; 33") de grille et à la zone (4' ; 25) supérieure de source/drain.

9. Procédé suivant la revendication 8, **caractérisé en ce que** la couche (9 ; 30) isolante, l'autre couche (18 ; 34) isolante et/ou le garnissage isolant contiennent de l'oxyde de silicium,
la première couche (5 ; 26) auxiliaire contient du nitrure de silicium et,
la couche conductrice contient du polysilicium dopé.

10. Procédé suivant la revendication 9, **caractérisé en ce que** la surface de la zone (8 ; 28) de connexion et/ou de l'électrode (15 ; 33") de grille et/ou de la zone (4'; 25) supérieure de source/drain est munie de siliciure métallique.
